# EUROPEAN PATENT APPLICATION

(11) **EP 4 664 528 A1**
(43) Date of publication of application: **17.12.2025**
(21) Application number: 25180019.9
(22) Date of filing: 30.05.2025
(51) Int. Cl.: H01L 25/075, H10H 20/01, H10H 29/80, H10H 20/857

(54) **LED MODULE MANUFACTURING METHOD AND LED MODULE**

(30) Priority: 05.06.2024 CN 202410724548
(71) Applicant: Leyard Optoelectronic Co., Ltd., Beijing 100091 (CN)
(72) Inventor: WANG, Mengqiang, Beijing, 100091 (CN); MA, Li, Beijing, 100091 (CN)
(74) Representative: HGF

(57) **Abstract**

The present invention provides an LED module manufacturing method and an LED module. The LED module manufacturing method includes: selecting a lamp bead substrate (10) and connecting a plurality of groups of LED chips to the lamp bead substrate; forming an encapsulation adhesive layer on the lamp bead substrate by an encapsulation adhesive to encapsulate the plurality of groups of LED chips; preparing a metal thin film layer on the encapsulation adhesive layer and preparing a metal wire grid (121), which has grid wires extending in the same direction, by the metal thin film layer; cutting the lamp bead substrate based on each group of LED chips; repeatedly performing the above steps; arranging the at least two types of LED lamp beads, which have metal wire grids (121) with grid wires extending in different directions, in an array on a module substrate (20) to obtain an LED module.

## Description

### Technical Field

The present invention relates to the technical field of LED, and specifically relates to an LED module manufacturing method and an LED module.

### Background

3D display technology is a new type of display technology. Compared with ordinary 2D image displays, 3D technology allows an image to become three-dimensional and realistic. The image is no longer confined to the plane of a screen, and it seems to extend beyond the screen, providing viewers with an immersive experience.

In related art, the 3D display technology includes two types: active 3D display and passive 3D display. The active 3D display uses electronic shutter technology, requiring an observer to wear shutter-type 3D glasses. Passive 3D display uses polarized 3D technology. The polarized 3D technology works by decomposing an original image based on the principle of light having a "vibration direction", first dividing the image into two sets of images: vertically polarized light and horizontally polarized light. Then, the 3D glasses use different polarized lenses for the left and right eyes. In this way, the left and right eyes of a person can receive the two sets of images, and the brain merges the two sets of images to form a 3D image. Polarized 3D technology, when combined with high-density integrated LED, has various technological advantages, such as comfort, portability, wide viewing angles, and high resolution, thereby being highly favored in the market.

Existing polarized 3D display technologies typically involve the attachment of polarized 3D films to LED lamp beads. However, due to errors that can occur during the attachment process between the polarized 3D films and the LED lamp bead, and the light from the LED lamp beads is in a free scattering state, issues such as light leakage at seams, phase differences at the junctions of adjacent rows and columns, and light interference or crosstalk can occur, affecting the 3D viewing effect.

### Summary

The present invention provides an LED module manufacturing method and an LED module to solve the problem of poor 3D display viewing effects of LED in related art.

According to an aspect of the present invention, an LED module manufacturing method is provided. The LED module manufacturing method includes: step S10, selecting a lamp bead substrate and connecting a plurality of groups of LED chips to a front surface of the lamp bead substrate; step S30, forming an encapsulation adhesive layer on the front surface of the lamp bead substrate by an encapsulation adhesive to encapsulate the plurality of groups of LED chips; step S40, preparing a metal thin film layer on a surface of the encapsulation adhesive layer facing away from the lamp bead substrate and preparing a metal wire grid, which has grid wires extending in a same direction, by the metal thin film layer; step S60, cutting the lamp bead substrate based on each group of LED chips to obtain a plurality of LED lamp beads; step S70, repeatedly performing the above steps to obtain at least two types of LED lamp beads, which have metal wire grids with grid wires extending in different directions; and step S80, arranging the at least two types of LED lamp beads, which have metal wire grids with grid wires extending in different directions, in an array on a module substrate to obtain an LED module.

Further, between the step S40 and the step S60, the method also includes: step S50, preparing a protective layer on a surface of the metal wire grid facing away from the lamp bead substrate.

Further, the step S40 includes: step S41, coating a transition material on a surface of the metal thin film layer facing away from the lamp bead substrate to form a transition layer; step S42, forming a transition wire grid by the transition layer; and step S43, using the transition wire grid as a mask to etch the metal thin film layer to form the metal wire grid.

Further, the step S42 includes imprinting the transition layer by a nanoimprint template to form the transition wire grid; and/or, the step S41 includes coating the transition material by a spin-coating process to form the transition layer.

Further, in the step S70, the LED lamp beads include first LED lamp beads and second LED lamp beads, where grid wires of the metal wire grid of the first LED lamp beads extend in a first direction, and grid wires of the metal wire grid of the second LED lamp beads extend in a second direction, where the first direction is perpendicular to the second direction; and/or, each group of LED chips includes a plurality of LED chips which are sequentially arranged in a straight line, and the first direction is perpendicular to an arrangement direction of the plurality of LED chips; and/or, each group of LED chips includes a plurality of LED chips which are sequentially arranged in a straight line, and the second direction is parallel to the arrangement direction of the plurality of LED chips.

Further, the step S80 includes: step S81, sequentially soldering a plurality of first LED lamp beads onto corresponding pads of the module substrate in a transverse direction of the module substrate; step S82, on side portions of the plurality of first LED lamp beads, sequentially soldering a plurality of second LED lamp beads onto corresponding pads of the module substrate in the transverse direction of the module substrate; and step S83, repeatedly performing the above steps to arrange the plurality of first LED lamp beads and the plurality of second LED lamp beads in a staggered manner in a longitudinal direction of the module substrate.

Further, the step S80 includes: step S84, sequentially soldering a plurality of first LED lamp beads onto corresponding pads of the module substrate in a longitudinal direction of the module substrate; step S85, on side portions of the plurality of first LED lamp beads, sequentially soldering a plurality of second LED lamp beads onto corresponding pads of the module substrate in the longitudinal direction of the module substrate; and step S86: repeatedly performing the above steps to arrange the plurality of first LED lamp beads and the plurality of second LED lamp beads in a staggered manner in a transverse direction of the module substrate.

Further, the step S80 includes: step S87, soldering the first LED lamp beads and the second LED lamp beads in a staggered manner onto corresponding pads of the module substrate, so that the first LED lamp beads and the second LED lamp beads are arranged adjacent to each other.

Further, between the step S10 and the step S30, the method also includes: step S20, preparing a plurality of dams on the lamp bead substrate, each dam being disposed around a periphery of a corresponding group of LED chips.

Another embodiment of the present invention provides an LED module, which is prepared by the LED module manufacturing method described above. The LED module includes a module substrate and a plurality of LED lamp beads arranged in an array on the module substrate. Each LED lamp bead comprises a lamp bead substrate, an LED chip, an encapsulation adhesive layer and a metal wire grid, where the LED chip is disposed on the lamp bead substrate, the encapsulation adhesive layer is disposed on the lamp bead substrate and encapsulates the LED chip, and the metal wire grid is disposed on a surface of the encapsulation adhesive layer facing away from the lamp bead substrate; and a part of the metal wire grid extends in a first direction, and a remaining part thereof extends in a second direction, an included angle being formed between the first and second directions.

According to the technical solution of the present invention, a plurality of groups of LED chips are connected to a front surface of a lamp bead substrate; an encapsulation adhesive is then used to form an encapsulation adhesive layer on the front surface of the lamp bead substrate to encapsulate the plurality of groups of LED chips; a metal thin film layer is prepared on a surface of the encapsulation adhesive layer facing away from the lamp bead substrate, and a metal wire grid is prepared by the metal thin film layer, wherein grid wires of the metal wire grid extend in the same direction; and the lamp bead substrate is then cut to obtain a plurality of LED lamp beads. Since the grid wires extend in the same direction in this step, the grid wires are preferably uniformly distributed, eliminating the need for high-precision alignment between the metal wire grid and the LED chips. By repeating the above steps, at least two different types of LED lamp beads are obtained, and the grid wires of the metal wire grids in different types of LED lamp beads extend in different directions. The at least two types of LED lamp beads, which have metal wire grids with grid wires extending in different directions, are arranged in an array on the module substrate to obtain an LED module. The metal wire grid can polarize the light emitted from the LED lamp beads, thereby producing a 3D viewing effect. In the above LED module manufacturing method, there is no need to attach a 3D polarizing film to the LED lamp beads, thus avoiding the alignment inaccuracy that occurs when attaching a polarizing film, and preventing light intrusion and optical crosstalk issues.

### Brief Description of the Drawings

The accompanying drawings, which constitute a part of the present invention, are used for providing a further understanding of the present invention; and illustrative embodiments of the present invention and descriptions thereof are intended to explain the present invention and are not construed to unduly limit the present invention. In the drawings:
FIG. 1 illustrates a flow diagram of an LED module manufacturing method according to an embodiment of the present invention;
FIG. 2 illustrates a schematic diagram of LED chips welded on a lamp bead substrate;
FIG. 3 illustrates a schematic diagram of prepared dams around a periphery of the LED chips;
FIG. 4 illustrates a schematic diagram of preparing a metal wire grid on surfaces of the LED chips;
FIG. 5 illustrates a schematic diagram of covering the surfaces of the LED chips with a metal thin film layer and a transition layer;
FIG. 6 illustrates a schematic diagram of preparing a transition wire grid by the transition layer;
FIG. 7 illustrates a schematic diagram of preparing a metal wire grid by the transition wire grid;
FIG. 8 illustrates a schematic diagram of coating a protective layer on a surface of the metal wire grid;
FIG. 9 illustrates a structural schematic diagram of an LED lamp bead of an LED module according to an embodiment of the present invention;
FIG. 10 illustrates a structural schematic diagram of an LED module according to an embodiment of the present invention;
FIG. 11 illustrates another structural schematic diagram of the LED module according to an embodiment of the present invention; and
FIG. 12 illustrates yet another structural schematic diagram of the LED module according to an embodiment of the present invention.

The following reference signs are involved in the accompanying drawings:
10, lamp bead substrate; 11, Encapsulation adhesive layer; 12, Metal thin film layer; 121, Metal wire grid; 13, LED lamp bead; 131, First LED lamp bead; 132, Second LED lamp bead; 14, Transition layer; 141, Transition wire grid; 15, Protective layer; 16, Dam; 17, LED chip; and
20, Module substrate.

### Detailed Description of the Embodiments

The technical solutions in the embodiments of the present invention will be clearly and completely described below in conjunction with the accompanying drawings in the embodiments of the present invention. Obviously, the described embodiments are only a part of the embodiments of the present invention, but not all of the embodiments. The following description of at least one exemplary embodiment is merely illustrative and shall in no way be construed as limiting the present invention or its applications and uses. Based on the embodiments of the present invention, all other embodiments obtained by those of ordinary skill in the art without creative efforts shall fall within the scope of protection of the present invention.

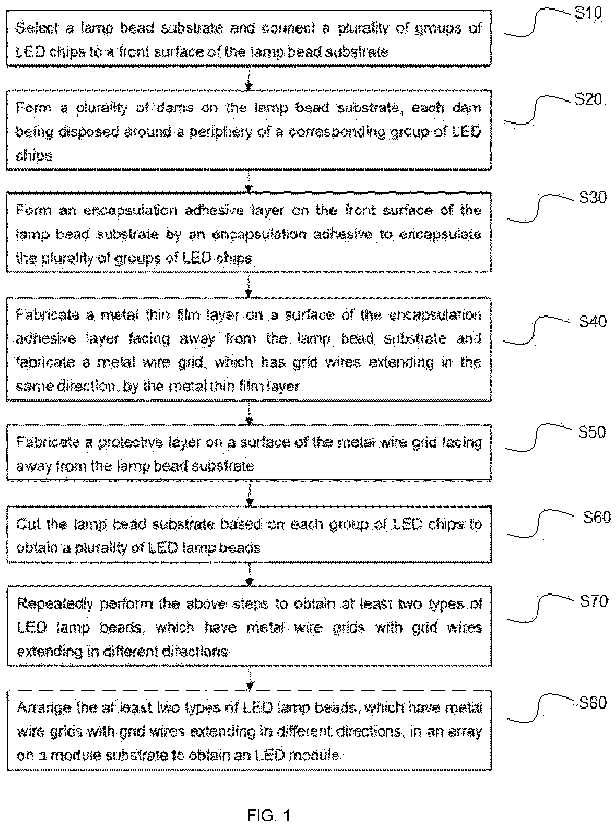

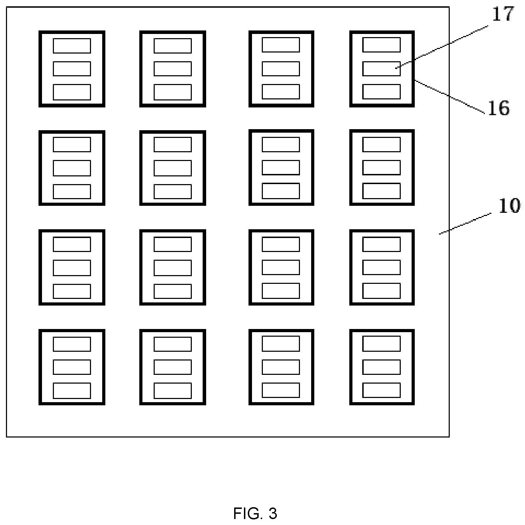

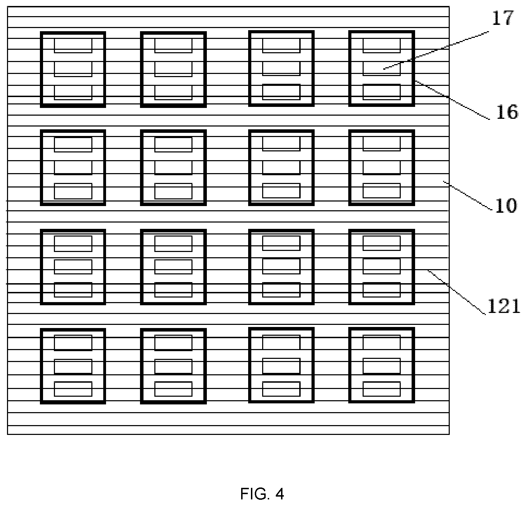

As shown in FIG. 1 to FIG. 12, the embodiments of the present invention provide an LED module manufacturing method. The LED module manufacturing method includes: step S10, selecting a lamp bead substrate 10 and connecting a plurality of groups of LED chips 17 to a front surface of the lamp bead substrate 10; step S30, forming an encapsulation adhesive layer 11 on the front surface of the lamp bead substrate 10 by an encapsulation adhesive to encapsulate the plurality of groups of LED chips 17; step S40, preparing a metal thin film layer 12 on a surface of the encapsulation adhesive layer 11 facing away from the lamp bead substrate 10 and preparing a metal wire grid 121, which have grid wires extending in the same direction, by the metal thin film layer 12; step S60, cutting the lamp bead substrate 10 based on each group of LED chips 17 to obtain a plurality of LED lamp beads 13; step S70, repeatedly performing the above steps to obtain at least two types of LED lamp beads 13, which have metal wire grids 121 with grid wires extending in different directions; and step S80, arranging the at least two types of LED lamp beads 13, which have metal wire grids 121 with grid wires extending in different directions, in an array on a module substrate 20 to obtain an LED module.

According to the technical solution of the present invention, the plurality of groups of LED chips 17 are connected to the front surface of the lamp bead substrate 10; the encapsulation adhesive is then used to form an encapsulation adhesive layer 11 on the front surface of the lamp bead substrate 10 to encapsulate the plurality of groups of LED chips 17; the metal thin film layer 12 is prepared on the surface of the encapsulation adhesive layer 11 facing away from the lamp bead substrate 10, and the metal wire grid 121 is prepared by the metal thin film layer 12, wherein grid wires of the metal wire grid 121 extend in the same direction; and the lamp bead substrate 10 is then cut to obtain the plurality of LED lamp beads 13. Since the grid wires extend in the same direction in this step, the grid wires are preferably uniformly distributed, eliminating the need for high-precision alignment between the metal wire grid 121 and the LED chips 17. By repeating the above steps, at least two different types of LED lamp beads 13 are obtained, and the grid wires of the metal wire grids 121 of different types of LED lamp beads 13 extend in different directions. The at least two types of LED lamp beads 13, which have metal wire grids 121 with grid wires extending in different directions, are arranged in an array on the module substrate 20 to obtain an LED module. The metal wire grid 121 can polarize the light emitted from the LED lamp beads 13, thereby producing a 3D viewing effect. In the above LED module manufacturing method, there is no need to attach a 3D polarizing film to the LED lamp beads 13, thus avoiding the alignment inaccuracy that occurs when attaching a polarizing film, and preventing light intrusion and optical crosstalk issues.

Moreover, since the metal wire grid 121 is prepared on the surface of the encapsulation adhesive of the LED lamp beads 13, at least two types of LED lamp beads 13, which have metal wire grids 121 with grid wires extending in different directions, are obtained. During the fabrication process of the LED module, it is only necessary to solder the LED lamp beads 13 onto the module substrate 20, without the need for precise alignment of the LED lamp beads 13.

In this embodiment, a plurality of LED lamp beads 13 can be prepared, with grid wires of the metal wire grids 121 in each type of LED lamp beads 13 extending in the same direction. Meanwhile, during the fabrication of an LED module, two types of LED lamp beads 13 are selected and arranged in an array on the module substrate 20 according to actual requirements, thereby obtaining the desired LED module.

It should be noted that an LED chip refers to an integrated circuit used to control three primary colors: red, green and blue. By adjusting the brightness of these three colors, various colors of light can be produced. Each group of LED chips 17 includes three LED chips 17, which respectively control the colors red, green, and blue. Each LED lamp bead 13 includes one group of LED chips 17.

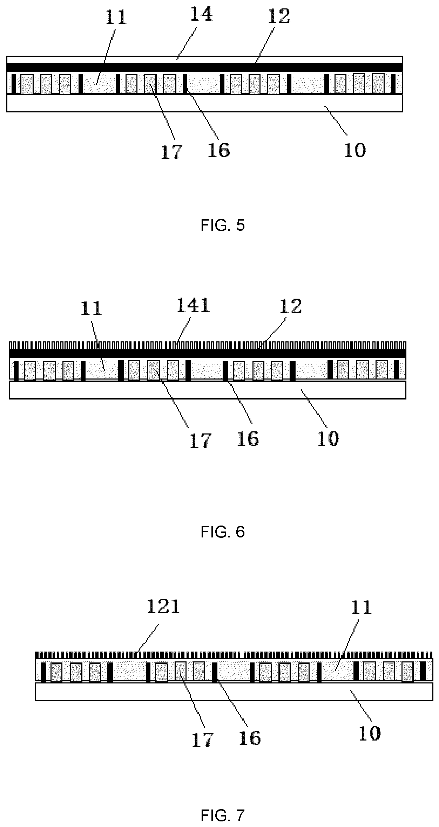

As shown in FIG. 5 to FIG. 7, the step S40 includes: step S41, coating a transition material on a surface of the metal thin film layer 12 facing away from the lamp bead substrate 10 to form a transition layer 14; step S42, forming a transition wire grid 141 by the transition layer 14; and step S43, using the transition wire grid 141 as a mask to etch the metal thin film layer 12 to form the metal wire grid 121. By adopting the above steps, the coating of the transition material on the upper surface of the metal thin film layer 12 serves as preparation for the subsequent fabrication of the metal wire grid 121. The transition layer is used to form the transition wire grid 141, which acts as a mask to transfer a pattern of the transition wire grid 141 onto the surface of the encapsulation adhesive layer 11, thereby preparing the metal thin film layer 12 to form the metal wire grid 121.

In this embodiment, the transition material is preferably photoresist.

The metal thin film layer 12 may be made of one of aluminum, gold, silver, copper and chromium, etc., and can be prepared by one of the processes such as electroplating, atomic layer deposition, or sputtering. The thickness of the metal wire grid 121 ranges from 10 to 150 nm, the width of the metal wire grid 121 ranges from 10 to 150 nm, and the spacing between adjacent grid wires ranges from 10 to 150 nm. The grid wires may be arranged in a horizontal or vertical direction.

In the step S43, by an etching process, the metal thin-film layer 12 can be etched by using the transition wire grid 141 as a mask, and then the transition material is stripped off, forming the metal wire grid 121 of a wire grid polarizer.

As shown in FIG. 6, the step S42 includes: imprinting the transition layer 14 by a nanoimprint template to form a transition wire grid 141. By adopting the nanoimprint technology, a pattern on the template can be transferred onto the transition layer 14 through physical imprint to form the transition wire grid 141.

The specific etching process may be dry etching or wet etching, preferably plasma dry etching.

As shown in FIG. 5, the S41 includes: coating a transition material by a spin-coating process to form a transition layer 14. By the above process, the transition material can be uniformly coated on the surface of the encapsulation adhesive layer 11 to form the transition layer 14.

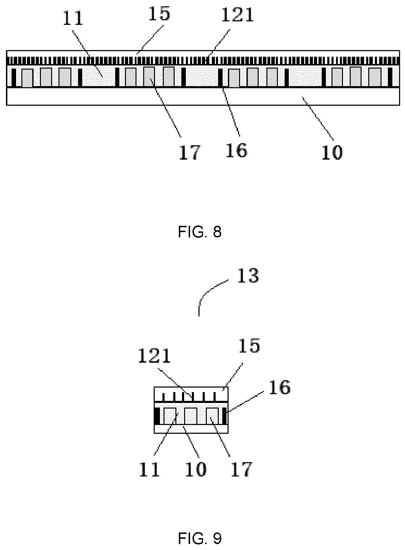

As shown in FIG. 8, between the step S40 and the step S60, the method further includes: step S50, preparing a protective layer 15 on a surface of the metal wire grid 121 facing away from the lamp bead substrate 10. The protective layer 15 can protect the metal wire grid 121.

In the step S70, the LED lamp beads 13 include first LED lamp beads 131 and second LED lamp beads 132, grid wires of the metal wire grid 121 of the first LED lamp beads 131 extend in a first direction, and grid wires of the metal wire grid 121 of the second LED lamp beads 132 extend in a second direction. In one embodiment, the first direction is perpendicular to the second direction.

In another embodiment, each group of LED chips 17 includes a plurality of LED chips 17 which are sequentially arranged in a straight line, and the first direction is perpendicular to an arrangement direction of the plurality of LED chips 17. The above straight line is parallel to the width direction of the LED chip 17.

In yet another embodiment, each group of LED chips 17 includes a plurality of LED chips 17 which are sequentially arranged in a straight line, and the second direction is parallel to an arrangement direction of the plurality of LED chips 17.

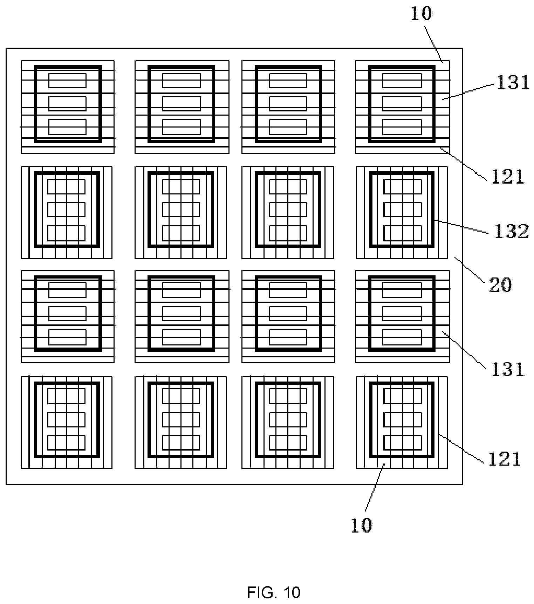

As shown in FIG. 10, the step S80 includes: step S81, sequentially soldering a plurality of first LED lamp beads 131 onto corresponding pads of the module substrate 20 in a transverse direction of the module substrate 20; step S82, on side portions of the plurality of first LED lamp beads 131, sequentially soldering a plurality of second LED lamp beads 132 onto corresponding pads of the module substrate 20 in the transverse direction of the module substrate 20; and step S83, repeatedly performing the above steps to arrange the plurality of first LED lamp beads 131 and the plurality of second LED lamp beads 132 in a staggered manner in a longitudinal direction of the module substrate 20. By the above steps, an LED module, in which the metal wire grids 121 of two adjacent rows of LED lamp beads 13 have different structures, can be obtained, thereby forming an LED module, in which first lamp bead rows and second lamp bead rows are arranged alternately, with a polarization effect.

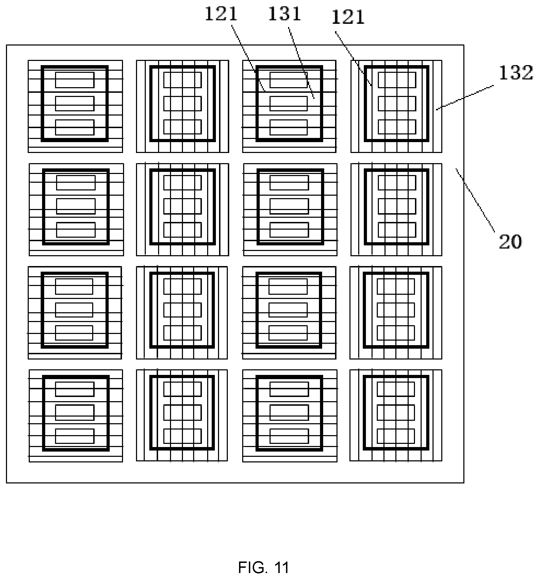

As shown in FIG. 11, the step S80 includes: step S84, sequentially soldering a plurality of first LED lamp beads 131 onto corresponding pads of the module substrate 20 in a transverse direction of the module substrate 20; step S85, on side portions of the plurality of first LED lamp beads 131, sequentially soldering a plurality of second LED lamp beads 132 onto corresponding pads of the module substrate 20 in a longitudinal direction of the module substrate 20; and step S86, repeatedly performing the above steps to arrange the plurality of first LED lamp beads 131 and the plurality of second LED lamp beads 132 in a staggered manner in the transverse direction of the module substrate 20. By the above steps, an LED module, in which the metal wire grids 121 of two adjacent columns of LED lamp beads 13 have different structures, can be obtained, thereby forming an LED module, in which first lamp bead columns and second lamp bead columns are arranged alternately, with a polarization effect.

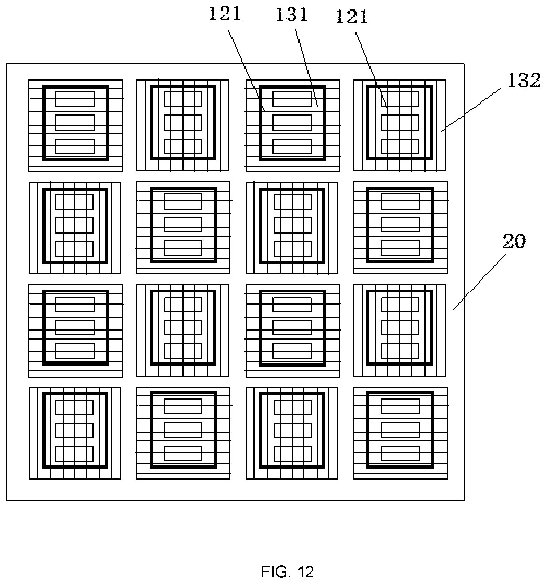

As shown in FIG. 12, the step S80 includes: step S87, soldering the first LED lamp beads 131 and the second LED lamp beads 132 in a staggered manner onto corresponding pads of the module substrate 20, so that the first LED lamp beads 131 and the second LED lamp beads 132 are arranged adjacent to each other. By the above steps, an LED module, in which the metal wire grids 121 of two adjacent LED lamp beads 13 have different structures, can be obtained, thereby forming a checkerboard type LED module with a polarization effect.

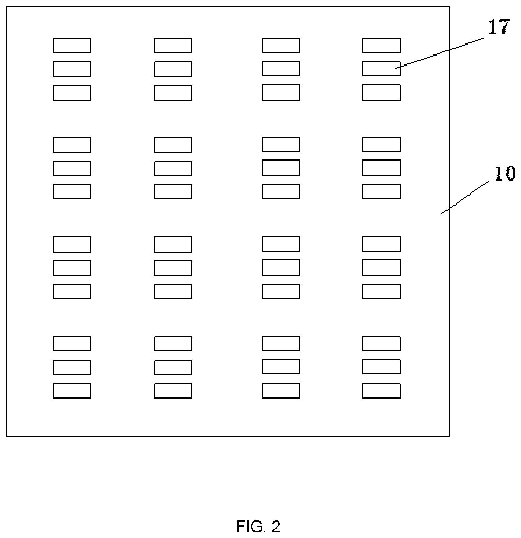

As shown in FIG. 2 to FIG. 4, between the step S10 and the step S30, the method further includes: step S20, preparing a plurality of dams 16 on the lamp bead substrate 10, each dam 16 being disposed around a periphery of a corresponding group of LED chips 17. By the above steps, the dams 16 are prepared around the periphery of each group of LED chips 17, which can block light from the LED chip and allow light to only exit from an upper surface of the LED chip 17, thereby preventing light leakage and reducing light crosstalk issues.

Each group of LED chips 17 serves as a pixel unit. A black surrounding barrier is prepared around a periphery of each pixel unit to form a dam 16. The manufacturing method can be printing by a 3D printer or dispensing by a glue dispenser, and the material of the black surrounding barrier is one of epoxy resin, acrylic resin and polyurethane resin. After the resin is cured, the black dam 16 is obtained. The height of the dam 16 is consistent with that of the LED chip 17, and the distance between the dam and the LED chip is 0 to 30 µm.

Specifically, a die bonder is used to bond the LED chips 17 onto the lamp bead substrate 10, where solder paste has been pre-printed. The specifications of chips can be selected based on actual requirements and may be any of the commonly used specifications on the market, such as 0203, 0305, 0406, 0408, etc. The material of the lamp bead substrate 10 may be a BT board, an FR4 board, or a PCB, with the BT board being preferred. An array of pads is arranged on a front surface of the lamp bead substrate 10 for connecting the LED chips 17 after solder paste printing. An array of pads is arranged on a back surface of the lamp bead substrate 10 for connection to the module substrate 20. The LED chips 17 are fixed onto the pads on the front surface of the lamp bead substrate 10, and the connection method may be reflow soldering, laser soldering, or other techniques, using solder paste or die attach adhesives as a bonding agent. Thus, the LED lamp beads 13 with an array of LED chips 17 are formed.

The composition of the encapsulation adhesive is one or more of polyimide resin, epoxy resin, and acrylic resin. The thickness of the encapsulation adhesive is 0.05 to 0.35 mm.

Another embodiment of the present invention provides an LED module, which is prepared by the LED module manufacturing method described above. The LED module includes a module substrate 20 and a plurality of LED lamp beads 13 arranged in an array on the module substrate 20. Each LED lamp bead 13 includes a lamp bead substrate 10, an LED chip 17, an encapsulation adhesive layer 11 and a metal wire grid 121, where the LED chip 17 is disposed on the lamp bead substrate 10, the encapsulation adhesive layer 11 is disposed on the lamp bead substrate 10 and encapsulates the LED chip 17, and the metal wire grid 121 is disposed on a surface of the encapsulation adhesive layer 11 facing away from the lamp bead substrate 10; and part of the metal wire grid 121 extends in a first direction, and the remaining part of the metal wire grid 121 extends in a second direction, an included angle being formed between the first and second directions. The metal wire grid 121 disposed on the encapsulation adhesive layer 11 can polarize the light emitted from the LED lamp beads 13, thereby producing a 3D viewing effect. There is no need to attach a 3D polarizing film to the LED lamp beads 13, thus avoiding the alignment inaccuracy that occurs when attaching a polarizing film, and preventing light interference and crosstalk issues.

In an embodiment, a plurality of first LED lamp beads 131 are arranged at intervals on the module substrate 20 in a transverse direction of the module substrate 20 to form a first lamp bead row, and a plurality of second LED lamp beads 132 are arranged at intervals on the module substrate 20 in the transverse direction of the module substrate 20 to form a second lamp bead row. A plurality of first lamp bead rows and a plurality of second lamp bead rows are arranged at intervals in a longitudinal direction of the module substrate 20. By the above structure, an LED module, in which the metal wire grids 121 of two adjacent rows of LED lamp beads 13 have different structures, can be obtained, thereby forming an LED module, in which first LED lamp bead rows and second LED lamp bead rows are arranged alternately, with a polarization effect.

In another embodiment, a plurality of first LED lamp beads 131 are arranged at intervals on the module substrate 20 in a longitudinal direction of the module substrate 20 to form a first lamp bead column, and a plurality of second LED lamp beads 132 are arranged at intervals on the module substrate 20 in the longitudinal direction of the module substrate 20 to form a second lamp bead column. A plurality of first lamp bead columns and a plurality of second lamp bead columns are arranged at intervals in a transverse direction of the module substrate 20. By the above structure, an LED module, in which the metal wire grids 121 of two adjacent columns of LED lamp beads 13 have different structures, can be obtained, thereby forming an LED module, in which first LED lamp bead columns and second LED lamp bead columns are arranged alternately, with a polarization effect.

In yet another embodiment, the first LED lamp beads 131 and the second LED lamp beads 132 are arranged adjacent to each other. By the above steps, an LED module, in which the metal wire grids 121 of two adjacent LED lamp beads 13 have different structures, can be obtained, thereby forming a checkerboard type LED module with a polarization effect.

The LED module provided by the present invention has the following beneficial effects:
1. The LED lamp beads 13 are prepared by a nanoimprint process, which features a simple process and facilitates large-scale production;
2. LED lamp beads 13 with metal wire grids 121 extending in the horizontal direction and LED lamp beads 13 with metal wire grids 121 extending in the vertical direction are separately prepared, and when soldering the LED lamp beads 13 onto the module substrate 20, precise alignment of each LED lamp bead 13 is not required;
3. No polarizing film is attached to the LED lamp beads 13, thus avoiding the alignment inaccuracy that occurs when the polarizing film is used, and preventing light interference and crosstalk issues between different pixel rows and columns;
4. The polarized LED lamp beads 13 prepared by this process are suitable for small-pitch LED displays, such as P0.9, P0.4, etc.; and
5. The application of the polarized LED lamp beads can meet the requirements for different types of polarized 3D displays, such as checkerboard-type, row-interlaced-type, or column-interlaced-type displays.

The following is a description of the specific embodiments:
Specific Embodiment 1
   (1) A die bonder is used to bond a plurality of LED chips 17 onto a lamp bead substrate 10 with pre-printed solder paste. The chip specification is 0406, the material of the lamp bead substrate 10 is a BT board, and the LED chips 17 are fixed onto the pads on the front surface of the lamp bead substrate 10 by means of reflow soldering;
   (2) Each group of LED chips 17 serves as a pixel unit. A glue dispenser is used to fabricate a black surrounding barrier around the periphery of each pixel unit with black epoxy resin. After curing, a black dam 16 is formed. The height of each dam 16 is the same as that of the LED chip, and the distance between the dam 16 and the LED chip 17 is 15 µm;
   (3) The LED chips 17 and the dams 16 are encapsulated by an epoxy resin encapsulation adhesive with a thickness of 0.25 mm;
   (4) The metal thin film layer 12 made of aluminum is prepared on the surface of the encapsulation adhesive layer 11 by a spluttering process;
   (5) A transition material, which is photoresist, is coated on the surface of the metal layer. A nanoimprint template is used to imprint the transition material, forming a transition wire grid 141 with horizontal grid wires. The transition wire grid 141 serves as a mask for plasma etching of the metal thin film layer 12. The transition material is then stripped to form a metal wire grid 121 of the wire grid polarizer;
   (6) A protective layer is prepared on a horizontal wire grid polarization structure;
   (7) The lamp bead substrate 10 is cut, and after cutting, the LED lamp bead has dimensions of 0.6 mm × 0.6 mm, thereby obtaining an LED lamp bead 13 with a metal wire grid 121 extending in the horizontal direction;
   (8) The nanoimprint template with a horizontal structure is replaced with a nanoimprint template with a vertical structure, and an LED lamp bead 13 with a metal wire grid 121 extending in the vertical direction is prepared again; and
   (9) A module substrate 20 with a pixel pitch of P1.25 is selected. The front surface of the module substrate 20 is provided with an array of pads for connection with the pads on the back surface of the lamp bead substrate 10 of the LED lamp beads 13. The back surface of the module substrate 20 is integrated with component for controlling LED to emit light. The first LED lamp beads 131 are soldered onto the odd-row pads on the front surface of the module substrate 20, and the second LED lamp beads 132 are soldered onto the even-row pads on the front surface of the module substrate 20, thereby forming a polarized LED module with a pixel pitch of P1.25, in which first LED lamp bead rows and second LED lamp bead rows are arranged alternately.
Specific Embodiment 2:
   The difference from Specific Embodiment 1 lies in that, in Embodiment 2, a module substrate 20 with a pixel pitch of P1.25 is selected. The front surface of the module substrate 20 is provided with an array of pads, which are used to connect with the pads on the back surface of the lamp bead substrate 10 of the LED lamp beads 13. The back surface of the module substrate 20 is integrated with component for controlling LED to emit light. The first LED lamp beads 131 are soldered onto the odd-column pads on the front surface of the module substrate 20, and the second LED lamp beads 132 are soldered onto the even-column pads on the front surface of the module substrate 20, thereby forming a polarized LED module with a pixel pitch of P1.25, in which first LED lamp bead columns and second LED lamp bead columns are arranged alternately.
Specific Embodiment 3:
   The difference from Specific Embodiment 1 lies in that, in Embodiment 3, a module substrate 20 with a pixel pitch of P0.9 is selected. The front surface of the module substrate 20 is provided with an array of pads, which are used to connect with the pads on the back surface of the lamp bead substrate 10 of the LED lamp beads 13. The back surface of the module substrate 20 is integrated with component for controlling LED to emit light. The first LED lamp beads 131 are soldered onto the pads in odd locations of odd rows and the pads in even locations of even rows on the front surface of the module substrate 20, and the second LED lamp beads 132 are soldered onto the pads in even locations of odd rows and the pads in odd locations of even rows on the front surface of the module substrate 20, thereby forming a checkerboard type polarized LED module with a pixel pitch of P0.9.

The foregoing is merely the preferred embodiments of the present invention and is not intended to limit the present invention which may be subject to various modifications and variations to those skilled in the art. Any modification, equivalent replacement, improvement, etc. made within the spirit and principles of the present invention should be included in the scope of protection of the present invention.

## Claims

1. An LED module manufacturing method, comprising:
step S10, selecting a lamp bead substrate (10) and connecting a plurality of groups of LED chips (17) to a front surface of the lamp bead substrate (10);
step S30, forming an encapsulation adhesive layer (11) on the front surface of the lamp bead substrate (10) by an encapsulation adhesive to encapsulate the plurality of groups of LED chips (17);
step S40, preparing a metal thin film layer (12) on a surface of the encapsulation adhesive layer (11) facing away from the lamp bead substrate (10) and preparing a metal wire grid (121), which has grid wires extending in a same direction, by the metal thin film layer (12);
step S60, cutting the lamp bead substrate (10) based on each group of LED chips (17) to obtain a plurality of LED lamp beads (13);
step S70, repeatedly performing above steps to obtain at least two types of LED lamp beads (13), which have metal wire grids (121) with grid wires extending in different directions; and
step S80, arranging the at least two types of LED lamp beads (13), which have metal wire grids (121) with grid wires extending in different directions, in an array on a module substrate (20) to obtain an LED module.

2. The LED module manufacturing method according to claim 1, wherein between the step S40 and the step S60, the method further comprises:
step S50, preparing a protective layer (15) on a surface of the metal wire grid (121) facing away from the lamp bead substrate (10).

3. The LED module manufacturing method according to claim 1, wherein the step S40 comprises:
step S41, coating a transition material on a surface of the metal thin film layer (12) facing away from the lamp bead substrate (10) to form a transition layer (14);
step S42, forming a transition wire grid (141) by the transition layer (14); and
step S43, using the transition wire grid (141) as a mask to etch the metal thin film layer (12) to form the metal wire grid (121).

4. The LED module manufacturing method according to claim 3, wherein the step S42 comprises: imprinting the transition layer (14) by a nanoimprint template to form the transition wire grid (141).

5. The LED module manufacturing method according to claim 1, wherein in the step S70, the LED lamp beads (13) comprise first LED lamp beads (131) and second LED lamp beads (132), grid wires of the metal wire grid (121) of the first LED lamp beads (131) extend in a first direction, and grid wires of the metal wire grid (121) of the second LED lamp beads (132) extend in a second direction, wherein the first direction is perpendicular to the second direction;
wherein each group of LED chips (17) comprises a plurality of LED chips (17) which are sequentially arranged in a straight line, and the first direction is perpendicular to an arrangement direction of the plurality of LED chips (17);
wherein each group of LED chips (17) comprises a plurality of LED chips (17) which are sequentially arranged in a straight line, and the second direction is parallel to an arrangement direction of the plurality of LED chips (17).

6. The LED module manufacturing method according to claim 5, wherein the step S80 comprises:
step S81, sequentially soldering a plurality of first LED lamp beads (131) onto corresponding pads of the module substrate (20) in a transverse direction of the module substrate (20);
step S82, on side portions of the plurality of first LED lamp beads (131), sequentially soldering a plurality of second LED lamp beads (132) onto corresponding pads of the module substrate (20) in the transverse direction of the module substrate (20); and
step S83, repeatedly performing above steps to arrange the plurality of first LED lamp beads (131) and the plurality of second LED lamp beads (132) in a staggered manner in a longitudinal direction of the module substrate (20).

7. The LED module manufacturing method according to claim 5, wherein the step S80 comprises:
step S84, sequentially soldering a plurality of first LED lamp beads (131) onto corresponding pads of the module substrate (20) in a longitudinal direction of the module substrate (20);
step S85, on side portions of the plurality of first LED lamp beads (131), sequentially soldering a plurality of second LED lamp beads (132) onto corresponding pads of the module substrate (20) in the longitudinal direction of the module substrate (20); and
step S86, repeatedly performing above steps to arrange the plurality of first LED lamp beads (131) and the plurality of second LED lamp beads (132) in a staggered manner in a transverse direction of the module substrate (20).

8. The LED module manufacturing method according to claim 5, wherein the step S80 comprises:
step S87, soldering the first LED lamp beads (131) and the second LED lamp beads (132) in a staggered manner onto corresponding pads of the module substrate (20), so that the first LED lamp beads (131) and the second LED lamp beads (132) are arranged adjacent to each other.

9. The LED module manufacturing method according to claim 3, wherein the step S41 comprises: coating the transition material by a spin-coating process to form the transition layer (14).

10. The LED module manufacturing method according to any one of claims 1 to 9, wherein between the step S10 and the step S30, the method further comprises:
step S20, preparing a plurality of dams (16) on the lamp bead substrate (10), each dam (16) being disposed around a periphery of a corresponding group of LED chips (17).

11. The LED module manufacturing method according to claim 1, wherein in the step S70, the LED lamp beads (13) comprise first LED lamp beads (131) and second LED lamp beads (132), grid wires of the metal wire grid (121) of the first LED lamp beads (131) extend in a first direction, and grid wires of the metal wire grid (121) of the second LED lamp beads (132) extend in a second direction, wherein the first direction is perpendicular to the second direction.

12. The LED module manufacturing method according to claim 1, wherein in the step S70, the LED lamp beads (13) comprise first LED lamp beads (131) and second LED lamp beads (132), grid wires of the metal wire grid (121) of the first LED lamp beads (131) extend in a first direction, and grid wires of the metal wire grid (121) of the second LED lamp beads (132) extend in a second direction, wherein each group of LED chips (17) comprises a plurality of LED chips (17) which are sequentially arranged in a straight line, and the first direction is perpendicular to an arrangement direction of the plurality of LED chips (17).

13. The LED module manufacturing method according to claim 1, wherein in the step S70, the LED lamp beads (13) comprise first LED lamp beads (131) and second LED lamp beads (132), grid wires of the metal wire grid (121) of the first LED lamp beads (131) extend in a first direction, and grid wires of the metal wire grid (121) of the second LED lamp beads (132) extend in a second direction, wherein each group of LED chips (17) comprises a plurality of LED chips (17) which are sequentially arranged in a straight line, and the second direction is parallel to an arrangement direction of the plurality of LED chips (17).

14. An LED module, prepared by the LED module manufacturing method according to any one of claims 1 to 13 and comprising a module substrate (20) and a plurality of LED lamp beads (13) arranged in an array on the module substrate (20), wherein each LED lamp bead (13) comprises a lamp bead substrate (10), an LED chip (17), an encapsulation adhesive layer (11) and a metal wire grid (121); the LED chip (17) is disposed on the lamp bead substrate (10), the encapsulation adhesive layer (11) is disposed on the lamp bead substrate (10) and encapsulates the LED chip (17), and the metal wire grid (121) is disposed on a surface of the encapsulation adhesive layer (11) facing away from the lamp bead substrate (10); and a part of the metal wire grid (121) extends in a first direction, and a remaining part of the metal wire grid (121) extends in a second direction, an included angle being formed between the first direction and the second direction.
